# EUROPÄISCHE PATENTSCHRIFT

(11) **EP 2 201 397 B1**
(45) Veröffentlichungstag und Bekanntmachung des Hinweises auf die Patenterteilung: **06.07.2011**
(21) Anmeldenummer: 08838816.0
(22) Anmeldetag: 14.10.2008
(51) Int. Cl.: G01R 31/36

(54) **VERFAHREN UND VORRICHTUNG ZUR MESSUNG VON ZELLENSPANNUNGEN IN EINER MEHRZAHL VON IN REIHE GESCHALTETEN AKKUMULATORZELLEN**
METHOD AND DEVICE FOR MEASURING CELL VOLTAGES IN A PLURALITY OF SERIES-CONNECTED ACCUMULATOR CELLS
PROCÉDÉ ET DISPOSITIF DE MESURE DE TENSIONS DE BATTERIES DANS UNE PLURALITÉ DE BATTERIES D'ACCUMULATEUR MONTÉES EN SÉRIE

(30) Priorität: 15.10.2007 DE 102007049528
(43) Veröffentlichungstag der Anmeldung: 30.06.2010
(73) Patentinhaber: Andreas Stihl AG & Co. KG, 71336 Waiblingen (DE)
(72) Erfinder: AUSTERSCHULTE, Burkhard, 21385 Amelinghausen (DE)
(74) Vertreter: Wasmuth, Rolf
(86) Internationale Anmeldenummer: PCT/DE2008/001649
(87) Internationale Veröffentlichungsnummer: WO 2009/049592

(56) Entgegenhaltungen:
- EP-A- 0 575 205
- EP-A- 1 750 139
- DE-A1- 10 051 984
- US-A1- 2004 051 534

## Beschreibung

Die Erfindung betrifft ein Verfahren und eine Vorrichtung zur Messung von Zellenspannungen von Akkumulatorzellen in einer Mehrzahl von in Reihe geschalteten Akkumulatorzellen, wie sie zum Beispiel in sogenannten Akkupacks oder Zellenpacks wie LiIon-Zellenpacks verwendet werden. Die Erfindung betrifft ferner ein Ladegerät für ein Akkupack mit einer solchen Vorrichtung.

Typische Einsatzgebiete dieser wieder aufladbaren Akkupacks sind zum Beispiel elektrische Werkzeugmaschinen, handgeführte Haushaltsgeräte wie z.B. Staubsauger, Taschenlampen, Reinigungsgeräte, oder andere Geräte zur Garten-, Baum- und Strauchpflege.

Akkupacks dieser und anderer Art enthalten im Allgemeinen eine Mehrzahl von in Reihe geschalteten einzelnen Akkumulatorzellen. Insbesondere bei LiIon-Akkupacks besteht dabei häufig die Notwendigkeit, die Spannungen über den einzelnen, in Reihe (d.h. seriell) geschalteten Zellen (sog. Einzel- oder Zellenspannung) zu messen, um damit zum Beispiel Kapazitätszustände des Akkupacks zu ermitteln oder Lade/Entladezyklen optimal steuern zu können.

Die Messungen dieser Zellenspannungen erfolgen im Allgemeinen in Bezug auf ein gemeinsames Potential, insbesondere den Minuspol der Reihenschaltung bzw. des Akkupacks. Hierbei entsteht häufig das Problem, dass während der Messungen der Zellenspannungen die einzelnen Zellen unterschiedlich stark belastet und somit außer Balance gebracht werden. Es hat sich gezeigt, dass sich durch diese Debalancierung die effektive Kapazität des Akkupacks vermindern kann.

So wird z.B. in der DE 103 47 110 eine Vorrichtung und ein Verfahren zum Messen einzelner Zellenspannungen in einem Zellenstapel eines Energiespeichers beschrieben. Dabei ist parallel zu jeder Zelle eine Reihenschaltung zweier Dioden angeordnet, deren Verbindungspunkte über jeweils einen Kondensator und einen Umschalter mit einem Differenzverstärker verbunden sind. In die Kondensatoren wird ein Wechselstrom bestimmter Frequenz und Amplitude eingespeist, der eine der Zellenspannung entsprechende Wechselspannung erzeugt, die nach Gleichrichtung zu einem massebezogenen Gleichspannungswert für die Zellenspannung umgewandelt wird.

Aus der DE 103 20 127 ist eine Steuervorrichtung und ein Steuerverfahren für eine Speicherbatterie bekannt, bei der/dem eine erste Steuereinrichtung zum Freigeben von in einer Speicherbatterie (Kondensator) gespeicherten Ladungen in dem Fall, in dem die Klemmenspannung der Speicherbatterie auf oder über einem vorgegebenen Schwellwert liegt, eine Temperatur-Erfassungseinrichtung zum Erfassen der Temperatur der Speicherbatterie, sowie eine zweite Steuereinrichtung vorgesehen ist, die den vorgegebenen Schwellwert in Abhängigkeit von der Temperatur der Speicherbatterie ändert. Indem bei einer durch eine Temperaturänderung verursachten Änderung der Klemmenspannung der Speicherbatterie der Schwellenwert ebenfalls verändert wird, soll eine unnötige Entladung vermieden und die gespeicherte Lademenge erhöht werden.

Die DE 100 51 984 offenbart eine Batteriespannungs-Messvorrichtung insbesondere für solche Batteriezellen, die aus einer Mehrzahl von seriell verbundenen Modulen mit jeweils einer Mehrzahl von seriell verbundenen Sekundärbatterien zusammengesetzt sind. Die Vorrichtung umfasst im Wesentlichen für jedes Modul jeweils einen Kondensator, der auf die Spannung des betreffenden Moduls aufgeladen wird, Schalter, die diesen Kondensator und das Modul verbinden und trennen, einen Spannungsfolger, der die Spannung über dem Kondensator ausgibt, sowie Schalter, die den Spannungsfolger und den Kondensator verbinden und trennen. Damit soll die Batteriespannung mit hoher Genauigkeit erfasst werden.

In der EP 1 750 139 wird eine Spannungsmessvorrichtung für eine Batteriezellen-Gruppe, die sich aus einer Mehrzahl von in Serie geschalteten Batteriezellen zusammensetzt, beschrieben. Die Messvorrichtung umfasst im Wesentlichen einen Abtastschalter zur Verbindung einer oder mehrerer, zu messenden Batteriezellen mit einem Kondensator, so dass dieser durch diese Batteriezellen aufgeladen wird, ein Messteil, das die Spannung an dem geladenen Kondensator als Messspannung erfasst und korrigiert, so dass der durch die Anschlusskapazitäten des Abtastschalters verursachte Spannungsfehler in der Messspannung reduziert wird, sowie einen Überspannungs-Schutzschalter, der unmittelbar vor dem Einschalten des Abtastschalters eingeschaltet wird und den Eingangsanschluss des Messteils erdet, so dass das Messteil vor Überspannungen geschützt ist. Damit soll im Wesentlichen die Messgenauigkeit erhöht und verhindert werden, dass Überspannungen an das Messteil gelangen.

Aus der US 2004/0051534 ist schließlich eine weitere Spannungsmessvorrichtung für eine Batteriezellen-Gruppe, die sich aus einer Mehrzahl von in Serie geschalteten Batteriezellen zusammensetzt, bekannt. Eine Anzahl von seriell geschalteten und über Schalter alternativ mit verschiedenen Zellen verbindbare Kondensatoren dienen zur Speicherung der Zellenspannungen, die A/D gewandelt und über analoge Schutzschalter einem Spannungsdetektor zugeführt werden. Ferner ist auch eine Rauschunterdrückung vorgesehen. Damit soll in zuverlässiger Weise die Batteriespannung mit geringem Messefehler gemessen werden.

Eine Aufgabe, die der Erfindung zu Grunde liegt, besteht deshalb darin, ein Verfahren und eine Vorrichtung zur Messung von Zellenspannungen von Akkumulatorzellen in einer Mehrzahl von in Reihe geschalteten Akkumulatorzellen (insbesondere in einem Akkupack) zu schaffen, mit dem/der die durch die genannten Messungen der Zellenspannungen an den einzelnen Zellen verursachte Debalancierung der Zellen-Reihenschaltung zumindest wesentlich vermindert werden kann.

Gelöst wird diese Aufgabe gemäß Anspruch 1 mit einem Verfahren zur Messung von Zellenspannungen von Akkumulatorzellen in einer Mehrzahl von in Reihe geschalteten Akkumulatorzellen mit einem gemeinsamen Bezugspotential, mit einer der Anzahl von zu messenden Zellen entsprechenden Anzahl von in Reihe geschalteten Messwiderständen, sowie einer Anzahl von Schaltern zwischen den Messwiderständen und den Zellen, über die durch Schließen jeweils einer der Messwiderstände zu einer der Zellen parallel schaltbar ist, mit folgenden Schritten:
- Schließen des mit einem ersten Pol einer zu messenden Zelle verbundenen Schalters sowie eines weiteren Schalters an einem Pol einer Zelle mit einer im Vergleich zu der zu messenden Zelle betragsmäßig höheren Spannung gegenüber dem Bezugspotential, und gegebenenfalls Öffnen aller anderen Schalter,
- Ermitteln und Speichern der an dem ersten Pol gegenüber dem Bezugspotential abfallenden Spannung;
- Öffnen des mit dem ersten Pol der zu messenden Zelle verbundenen Schalters und Schließen des mit einem zweiten Pol der zu messenden Zelle verbundenen Schalters,
- Ermitteln und Speichern der an dem zweiten Pol gegenüber dem Bezugspotential abfallenden Spannung,
- Ermitteln der Zellenspannung durch Differenzbildung der über den beiden Polen ermittelten Spannungen.

Die Aufgabe wird ferner gemäß Anspruch 4 mit einer Vorrichtung zur Messung von Zellenspannungen von Akkumulatorzellen in einer Mehrzahl von in Reihe geschalteten Akkumulatorzellen mit einem gemeinsamen Bezugspotential gelöst, wobei die Vorrichtung aufweist:
- eine der Anzahl von zu messenden Zellen entsprechende Anzahl von in Reihe geschalteten Messwiderständen,
- eine Anzahl von Schaltern zwischen den Messwiderständen und den Zellen oder Anschlüssen für die Zellen, über die durch Schließen jeweils einer der Messwiderstände zu einer der Zellen parallel schaltbar ist, sowie
- eine Mess- und Steuereinrichtung zum Öffnen bzw. Schließen der Schalter in Abhängigkeit von einer gewählten, zu messenden Zelle, sowie zur Ermittlung der Zellenspannung der Zelle durch Differenzbildung der über den beiden Polen der Zelle gegenüber dem Bezugspotential abfallenden Spannung gemäß dem oben genannten Verfahren.

Ein besonderer Vorteil dieser Lösungen besteht darin, dass damit eine Debalancierung zumindest so weit vermindert werden kann, dass diese im Gegensatz zu bekannten Lösungen keinen relevanten Einfluss mehr auf die Störsicherheit, die Messgenauigkeit, die Abtastzeit, die Reaktionszeit, die Messzeit oder andere Parameter hat.

Weiterhin sind das erfindungsgemäße Verfahren und die erfindungsgemäße Vorrichtung zum Messen der Zellen von Akkupacks mit einer nahezu beliebigen Anzahl von Zellen anwendbar.

Die Unteransprüche haben vorteilhafte Weiterbildungen der Erfindung zum Inhalt.

Weitere Einzelheiten, Merkmale und Vorteile der Erfindung ergeben sich aus der folgenden Beschreibung einer beispielhaften und bevorzugten Ausführungsform anhand der Zeichnung. Es zeigt:

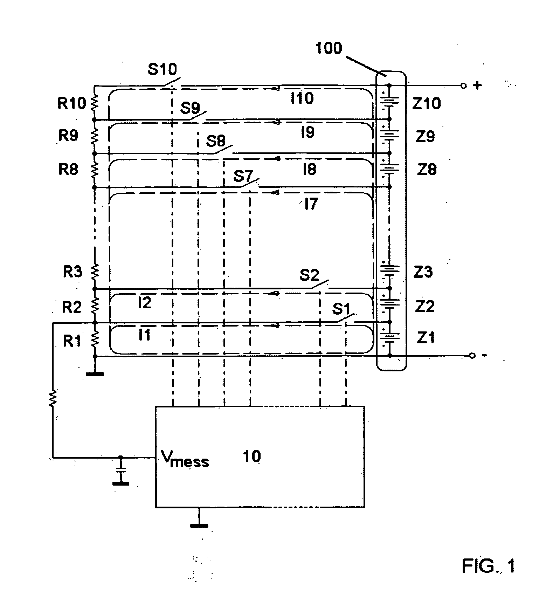

Fig. 1 ein schematisches Blockschaltbild einer solchen bevorzugten Ausführungsform der Erfindung.

Allgemein umfasst eine erfindungsgemäße Vorrichtung zur Messung von Zellenspannungen eine der Anzahl von zu messenden, in Reihe geschalteten Zellen Zi entsprechende Anzahl von in Reihe geschalteten Messwiderständen Ri, sowie zwischen den Messwiderständen und den Zellen eine Anzahl von Schaltern Si, über die durch Schließen jeweils einer der Messwiderstände parallel zu einer der Zellen geschaltet werden kann. Die Messwiderstände Ri und Schalter Si sind somit so angeordnet, dass zu jeder zu messenden Zelle Zi jeweils ein Messwiderstand Ri parallel geschaltet werden kann und alle Messwiderstände Ri in Reihe geschaltet sind.

Die Reihenschaltung der Messwiderstände ist dabei parallel zu der Reihenschaltung der Zellen geschaltet, das heißt die beiden äußeren Anschlüsse der Reihenschaltung der Messwiderstände sind jeweils mit den äußeren Anschlüssen der Reihenschaltung der Zellen verbunden. Einer der beiden äußeren Anschlüsse der Zellen-Reihenschaltung (vorzugsweise der Minuspol) bildet das Bezugspotential für die Messungen der Zellenspannungen über den Zellen, so dass in dieser Verbindung zu dem betreffenden äußeren Anschluss der Reihenschaltung der Messwiderstände auf Grund des gemeinsamen Bezugspotentials kein Schalter vorhanden zu sein braucht.

Der Vollständigkeit halber sei angemerkt, dass dies natürlich entsprechend auch in dem Fall gilt, in dem als Bezugspotential ein Nullpotential innerhalb der Reihenschaltung der Zellen gewählt und an den äußeren Anschlüssen der Reihenschaltung eine positive bzw. negative Spannung in Bezug auf das über einen entsprechenden dritten äußeren (z.B. mittleren) Anschluss herausgeführte Nullpotential zur Verfügung gestellt wird, so dass das erfindungsgemäße Prinzip auch in diesem Fall anwendbar ist.

Die Messwiderstände Ri haben alle die gleiche Größe, sofern die Nennspannungen der einzelnen Zellen Zi auch alle jeweils gleich groß sind. Sofern eine der Zellen eine höhere Nennspannung aufweist, als die anderen Zellen, ist auch der zu dieser Zelle parallel schaltbare Messwiderstand im gleichen Verhältnis größer zu bemessen als die zu den anderen Zellen parallel schaltbaren Messwiderstände der Reihenschaltung.

Die erfindungsgemäße Vorrichtung umfasst weiterhin eine Mess- und Steuereinrichtung, mit der gemäß dem erfindungsgemäßen Verfahren die Schalter Si in Abhängigkeit von derjenigen Zelle, deren Zellenspannung ermittelt werden soll, geöffnet bzw. geschlossen werden, um dann aus den gemessenen, über einem der Messwiderstände Ri abfallenden Spannungen die Zellenspannung zu berechnen.

Dabei wird eine Zellenspannung über einer zu messenden Zelle durch Differenzbildung derjenigen Spannungen ermittelt, die an den beiden Polen der zu messenden Zelle gegenüber dem Bezugspotenzial anliegen.

Zur Ermittlung dieser beiden Spannungen wird vorzugsweise die über demjenigen Messwiderstand abfallende (Mess-)Spannung gemessen, der mit einem seiner Anschlüsse (der auch einen äußeren Anschluss der Reihenschaltung darstellt) mit dem Bezugspotential verbunden ist ("erster" Messwiderstand R1). Die beiden Spannungen an den Polen der zu messenden Zelle werden jeweils unter Berücksichtigung des Teilerverhältnisses zwischen der zwischen dem betreffenden Pol der zu messenden Zelle und dem Bezugspotential liegenden Reihenschaltung der Messwiderstände und dem ersten Messwiderstand ermittelt. Dies hat den Vorteil, dass der Messabgriff für die Messspannung bei der Ermittlung aller Zellenspannungen über allen Zellen der gleiche sein kann (nämlich an dem mit dem Bezugspotential verbundenen, ersten Messwiderstand R1) und somit nicht mittels weiterer Schalter o.ä. verändert werden muss.

Zur Ermittlung der an einem Pol einer zu messenden Zelle anliegenden Spannung gegenüber dem Bezugspotential wird mittels der Mess- und Steuereinrichtung der mit diesem Pol verbundene Schalter geschlossen. Ferner wird mindestens ein weiterer Schalter an einem Pol einer Zelle mit einer im Vergleich zu der zu messenden Zelle höheren Spannung gegenüber dem Bezugspotential geschlossen, vorzugsweise der Schalter mit der höchsten Spannung (im Allgemeinen der Schalter an dem Pluspol der Zellen-Reihenschaltung). Alle anderen Schalter sind hingegen geöffnet. (Ergänzend sei angemerkt, dass in dem Fall, in dem der Pluspol als Bezugspotential gewählt wird, ein Schalter an einem Pol einer Zelle mit einer im Vergleich zu der zu messenden Zelle betragsmäßig höheren Spannung gegenüber dem Bezugspotential geschlossen wird, vorzugsweise der Schalter am Minuspol der Zellen-Reihenschaltung).

Damit wird, wie unten noch im Detail erläutert werden wird, erreicht, dass durch alle Zellen der Reihenschaltung sowie den geschlossenen Schalter an der Zelle mit der höchsten Spannung und die mit diesem Schalter verbundene Reihenschaltung der Messwiderstände der gleiche Messstrom zum Bezugspotential fließt, während über den geschlossenen Schalter am Pol der zu messenden Zelle kein (wesentlicher) Strom fließt, da dort kein Potentialunterschied zu den mit diesem Schalter verbundenen Messwiderständen besteht bzw. durch einen Stromfluss ausgeglichen werden könnte.

Weitere Details sollen nun anhand des in Figur 1 gezeigten Ausführungsbeispiels der Erfindung erläutert werden.

Figur 1 zeigt schematisch ein Akkupack 100, das eine Mehrzahl von einzelnen Akkumulatorzellen Zi mit jeweils zumindest im wesentlichen gleicher Zellen-Nennspannung, im dargestellten Fall beispielhaft eine erste bis zehnte Zelle Z1,...Z10, aufweist, die in Reihe geschaltet sind, wobei die äußeren Anschlüsse der Reihenschaltung (d. h. der Pluspol der zehnten Zelle Z10 bzw. der Minuspol der ersten Zelle Z1) einen Pluspol (+) bzw. einen Minuspol (-) des Akkupacks 100 bilden. Der Minuspol soll dabei das Bezugspotenzial für die Messungen der Spannungen darstellen.

Die erfindungsgemäße Vorrichtung umfasst einen ersten bis zehnten Messwiderstand R1,...R10 mit jeweils gleichem Widerstandswert, die in Reihe geschaltet sind, sowie einen ersten bis zehnten Schalter S1,...S10, über die jeweils eine Verbindung zwischen einem Pluspol einer der Zellen Z1,...Z10 und dem dazu jeweils parallel schaltbaren Messwiderstand R1,...R10 hergestellt werden kann.

Weiterhin ist in Figur 1 die Mess- und Steuereinrichtung 10 dargestellt, die zur Betätigung jedes Schalters S1,...S10 jeweils einen Schaltausgang aufweist. Die Mess- und Steuereinrichtung 10 umfasst ferner einen Spannungs-Messeingang, dem die über dem ersten Messwiderstand R1 abfallende Messspannung Vₘₑₛₛ zur Messung zugeführt wird.

Die Mess- und Steuereinrichtung 10 ist vorzugsweise mittels eines Mikroprozessors aufgebaut. Die Schalter S1,...S10 sind vorzugsweise in Form von schaltbaren Halbleiterschaltern wie zum Beispiel Bipolartransistoren, MOSFETs oder ähnlichem ausgeführt.

In Figur 1 sind schließlich mit gestrichelten Linien erste bis zehnte Ströme I1,...I10 angedeutet, die jeweils vom Pluspol einer der Zellen Z1,...Z10 über den damit verbundenen (geschlossenen) Schalter S1,...S10 und die damit verbundene Reihenschaltung der Messwiderstände R1,...R10 nach Masse fließen.

Zur Ermittlung der Zellenspannung über einer der Zellen Z1,...Z9 wird zum einen der Schalter an dieser Zelle, d.h. der mit dem Pluspol dieser zu messenden Zelle verbundene (zugehörige) Schalter S1,...S9 geschlossen.

Zum anderen wird mindestens ein weiterer Schalter an einer Zelle mit einer in Bezug auf das Bezugspotential höheren Spannung, vorzugsweise der Schalter an der Zelle mit der höchsten Spannung, bei der in Figur 1 gezeigten Ausführungsform also der zehnte Schalter S10, ebenfalls geschlossen. Als weitere bevorzugte Alternative könnten auch die Schalter aller Zellen mit höherer Spannung als der zu messenden Zelle geschlossen werden. Alle anderen Schalter bleiben bzw. werden geöffnet.

In dem Fall, in dem als weiterer Schalter der zehnte Schalter S10 geschlossen wird, wird erreicht, dass sich, ausgehend von einem balancierten Akkupack 100, aufgrund des gemeinsamen gleichen Messstroms I10 durch alle Zellen Z1,...Z10 und alle Messwiderstände R10,...R1 über allen Zellen Z1,...Z10 die gleichen Spannungen einstellen. Dies hat zur Folge, dass der über den geschlossenen Schalter Si der zu messenden Zelle fließende Strom minimal oder im wesentlichen Null ist. Da zu jedem Zeitpunkt durch jeder Zelle Z1, ...Z10 der gleiche Strom fließt, wird durch die Messung keine Debalancierung verursacht. Darüber hinaus wird ein eventueller debalancierter Zustand der Zellen durch die erfindungsgemäße Vorrichtung weitestgehend balanciert.

Beispielsweise ergibt sich bei einer Gesamt-Nennspannung des Akkupacks 100 zwischen den äußeren Anschlüssen von 40V, geschlossenem zehnten Schalter S10 und balancierten Zellen über jeder Zelle Z1, ...Z10 und über jedem Messwiderstand R1,...R10 jeweils ein Nennspannungsabfall von 4V. Betrachtet man nun z.B. die Messung der Spannung am Pluspol der achten Zelle Z8, so verändert sich die Spannung über der Reihenschaltung des achten bis ersten Messwiderstandes R8, ...R1 durch das Schließen des achten Schalters S8 nicht. Der Grund liegt darin, dass die Spannung über der Reihenschaltung der Messwiderstände R1 bis R8 und die Gesamtspannung über den Zellen Z1 bis Z8 jeweils gleich groß sind, in diesem Falle jeweils 8*4V=32V. Da durch das Schließen des achten Schalters S8 kein Potentialunterschied ausgeglichen wird, ist der betreffende achte Strom I8 durch diesen achten Schalter S8 im wesentlichen gleich Null. Der Messstrom I10 wird weiterhin nur durch den zehnten Schalter S10 und die Reihenschaltung der Messwiderstände R10, ...R1 geführt. Da dieser Messstrom auch durch alle Zellen Z1, ...Z10 fließt, wird das Akkupack 100 nicht debalanciert.

Die Zellenspannung über einer bestimmten Zelle Z1, ...Z10 wird durch Subtraktion zweier Messspannungen Vₘₑₛₛ, die an dem ersten Messwiderstand R1 abfallen, und unter Berücksichtigung der jeweiligen Spannungsteilerverhältnisse aufgrund der Messwiderstände Ri wie folgt ermittelt.

Wenn zum Beispiel die tatsächliche Zellenspannung über der achten Zelle Z8 ermittelt werden soll, wird mittels der Mess- und Steuereinrichtung 10 der achte Schalter S8 und vorzugsweise wie oben erläutert der zehnte Schalter S10 geschlossen. Dann wird mittels der Mess- und Steuereinrichtung 10 der Spannungsabfall an dem ersten Messwiderstand R1, d.h. die Messspannung Vₘₑₛₛ gemessen und gespeichert. Anschließend wird der achte Schalter S8 geöffnet und der siebte Schalter S7 geschlossen. Nun wird wiederum mittels der Mess- und Steuereinrichtung 10 die Messspannung Vₘₑₛₛ an dem ersten Messwiderstand R1 gemessen und gespeichert.

Die nach dem Schließen des achten Schalters S8 gemessene Messspannung Vₘₑₛₛ wird dann mittels der Mess- und Steuereinrichtung 10 mit dem Spannungsteilerverhältnis (R1 + R2 + ...R8) / R1 multipliziert, so dass sich die über der Reihenschaltung der Widerstände R1 bis R8 und damit die über den in Reihe geschalteten Zellen Z1 bis Z8 liegende Summenspannung ergibt.

Eine entsprechende Berechnung wird auch für die nach dem Schließen des siebten Schalters S7 gemessene und gespeicherte Messspannung Vₘₑₛₛ vorgenommen, das heißt diese Messspannung wird mit dem Spannungsteilerverhältnis (R1 + R2 + ...R7) / R1 multipliziert, so dass sich die über der Reihenschaltung der Widerständen R1 bis R7 abfallende Spannung bzw. die Summenspannung über den Zellen Z1 bis Z7 ergibt.

Durch Subtraktion dieser beiden berechneten Spannungen voneinander erhält man schließlich die gewünschte tatsächliche Zellenspannung über der achten Zelle Z8.

Die beiden oben genannten Spannungsteilerverhältnisse sind für sämtliche Messspannungen vorzugsweise in der Mess- und Steuereinrichtung 10 gespeichert, so dass sie nicht für jede Messung neu berechnet werden müssen.

Die Mess- und Steuereinrichtung 10 ist vorzugsweise so ausgelegt, dass ein Benutzer eine zu messende Zelle auswählen bzw. eingeben kann und die Mess- und Steuereinrichtung 10 dann in Abhängigkeit davon gemäß dem oben beschriebenen Verfahren die betreffenden Schalter öffnet bzw. schließt und die über der ausgewählten Zelle liegende Zellenspannung berechnet und anzeigt. Die Mess- und Steuereinrichtung 10 weist zu diesem Zweck vorzugsweise eine entsprechend programmierte Mikroprozessoreinheit, einen Speicher sowie eine Ein- und Ausgabeeinrichtung auf.

Sofern die Zellen Z1, ...Z10 des Akkupacks 100 unterschiedliche Zellenspannungen aufweisen, sind die Widerstandswerte der in Reihe geschalteten Messwiderstände R1, ...R10 entsprechend den Spannungsverhältnissen der Zellenspannungen zueinander entsprechend so anzupassen, dass über jedem Messwiderstand die gleiche Spannung abfällt wie an der betreffenden parallel dazu liegenden Zelle, wenn der zehnte Schalter geschlossen und alle anderen Schalter offen sind.

Die erfindungsgemäße Vorrichtung kann vorteilhaft zum Beispiel in Kombination mit einem Ladegerät verwendet werden, um den Zustand der einzelnen Zellen während eines Lade-/Entladevorgangs zu überwachen.

## Patentansprüche

1. Verfahren zur Messung von Zellenspannungen von Akkumulatorzellen in einer Mehrzahl von in Reihe geschalteten Akkumulatorzellen mit einem gemeinsamen Bezugspotential, mit einer der Anzahl von zu messenden Zellen (Zi) entsprechenden Anzahl von in Reihe geschalteten Messwiderständen (Ri), sowie einer Anzahl von Schaltern (Si) zwischen den Messwiderständen und den Zellen, über die durch Schließen jeweils einer der Messwiderstände zu einer der Zellen parallel schaltbar ist, mit folgenden Schritten:
- Schließen des mit einem ersten Pol einer zu messenden Zelle verbundenen Schalters sowie eines weiteren Schalters an einem Pol einer Zelle mit einer im Vergleich zu der zu messenden Zelle betragsmäßig höheren Spannung gegenüber dem Bezugspotential, und gegebenenfalls Öffnen aller anderen Schalter,
- Ermitteln und Speichern der an dem ersten Pol gegenüber dem Bezugspotential abfallenden Spannung;
- Öffnen des mit dem ersten Pol der zu messenden Zelle verbundenen Schalters und Schließen des mit einem zweiten Pol der zu messenden Zelle verbundenen Schalters,
- Ermitteln und Speichern der an dem zweiten Pol gegenüber dem Bezugspotential abfallenden Spannung,
- Ermitteln der Zellenspannung durch Differenzbildung der über den beiden Polen ermittelten Spannungen.

2. Verfahren nach Anspruch 1, bei dem die an einem Pol einer zu messenden Zelle (Zi) gegenüber dem Bezugspotential abfallende Spannung **dadurch** ermittelt wird, dass die über einem mit dem Bezugspotential verbundenen, ersten Messwiderstand (R1) der Reihenschaltung von Messwiderständen (Ri) abfallende Spannung gemessen und daraus unter Berücksichtigung des Teilerverhältnisses zwischen der zwischen dem Pol und dem Bezugspotential liegenden Reihenschaltung von Messwiderständen und dem ersten Messwiderstand (R1) die an dem Pol abfallende Spannung berechnet wird.

3. Verfahren nach Anspruch 2, bei dem das Öffnen und Schließen der Schalter (Si), die Berechnung der an den Polen einer zu messenden Zelle (Zi) abfallenden Spannungen, sowie die Berechnung der Zellenspannung mittels einer mikroprozessorgesteuerten Mess- und Steuereinrichtung (10) erfolgt.

4. Vorrichtung zur Messung von Zellenspannungen von Akkumulatorzellen in einer Mehrzahl von in Reihe geschalteten Akkumulatorzellen (Zi) mit einem gemeinsamen Bezugspotential, mit:
- einer der Anzahl von zu messenden Zellen (Zi) entsprechenden Anzahl von in Reihe geschalteten Messwiderständen (Ri),
- einer Anzahl von Schaltern (Si) zwischen den Messwiderständen und den Zellen oder Anschlüssen für die Zellen, über die durch Schließen jeweils einer der Messwiderstände zu einer der Zellen parallel schaltbar ist, sowie
- einer Mess- und Steuereinrichtung (10) zum Öffnen bzw. Schließen der Schalter (Si) in Abhängigkeit von einer gewählten, zu messenden Zelle, sowie zur Ermittlung der Zellenspannung der Zelle durch Differenzbildung der über den beiden Polen der Zelle gegenüber dem Bezugspotential abfallenden Spannung, nach einem Verfahren gemäß einem der Ansprüche 1 bis 3.

5. Vorrichtung nach Anspruch 4, bei der die Mess- und Steuereinrichtung (10) eine Recheneinheit und/oder eine Speichereinheit zum Berechnen bzw. Speichern mindestens eines Spannungsteilerverhältnisses zwischen einer zwischen einen Pol einer zu messenden Zellen (Zi) und das Bezugspotential zu schaltenden Reihenschaltung von Messwiderständen (R1 + R2 + R3 + ...) und einem mit dem Bezugspotential verbundenen, ersten Messwiderstand (R1) aufweist.

6. Vorrichtung nach Anspruch 4 oder 5, bei der die Mess- und Steuereinrichtung (10) eine Mikroprozessoreinheit sowie einen Speicher aufweist, zur Erfassung und Speicherung der an ihrem Eingang anliegenden Messspannung (Vₘₑₛₛ), zum Öffnen und Schließen der Schalter (Si) in Abhängigkeit von einer durch einen Benutzer ausgewählten, zu messenden Zelle, und zur Berechnung der Zellenspannung, nach einem Verfahren gemäß einem der Ansprüche 1 bis 3.

7. Ladegerät mit einer Vorrichtung nach einem der Ansprüche 4 bis 6.

## Claims

1. Method for measuring cell voltages of accumulator cells in a plurality of series-connected accumulator cells with a common reference potential, with a number of series-connected measuring resistors (Ri) corresponding to the number of cells (Zi) to be measured, and with a number of switches (Si) between the measuring resistors and the cells, by means of closing one of which switches a parallel connection can be established between one of the measuring resistors and one of the cells, the method comprising the following steps:
- the closing of the switch connected to a first terminal of a cell to be measured and of a further switch on a terminal of a cell having a higher voltage in comparison to the reference potential than the cell to be measured, and possibly the opening of all other switches,
- the determination and storage of the voltage dropping at the first terminal in comparison to the reference potential,
- the opening of the switch connected to the terminal of the cell to be measured and the closing of the switch connected to the second terminal of the cell to be measured,
- the determination and storage of the voltage dropping at the second terminal in comparison to the reference potential,
- the determination of the cell voltage by calculating the differential between the voltages determined across the two terminals.

2. Method according to claim 1, wherein the voltage dropping at a terminal of a cell (Zi) to be measured in comparison to the reference potential is determined by measuring the voltage dropping across a first measuring resistor (R1) of the series-connection of measuring resistors (Ri), which is connected to the reference potential, and by calculating therefrom the voltage dropping at the terminal, taking into account the divider ratio between the series-connection of measuring resistors lying between the terminal and the reference potential and the first measuring resistor (R1).

3. Method according to claim 2, wherein the opening and closing of the switches (Si), the calculation of the voltages dropping at the poles of a cell (Zi) to be measured and the calculation of the cell voltage are performed by a microprocessor-controlled measuring and control device (10).

4. Device for measuring cell voltages of accumulator cells in a plurality of series-connected accumulator cells (Zi) with a common reference potential, comprising:
- a number of series-connected measuring resistors (Ri) corresponding to the number of cells (Zi) to be measured,
- a number of switches (Si) between the measuring resistors and the cells or the connections for the cells, by means of closing one of which switches a parallel connection can be established between one of the measuring resistors and one of the cells, and
- a measuring and control device (10) for opening or closing the switches (Si) in dependence on a selected cell to be measured and the determination of the cell voltage by calculating the differential of the voltage dropping across the two terminals of the cell in comparison to the reference potential, in accordance with a method according to any of claims 1 to 3.

5. Device according to claim 4, wherein the measuring and control device (10) comprises a computing unit and/or a memory unit for the calculation and storage of at least one voltage divider ratio between a series connection of measuring resistors (R1 + R2 + R3 + ...) to be connected between a terminal of a cell (Zi) to be measured and the reference potential on the one hand and a first measuring resistor (R1) connected to the reference potential on the other hand.

6. Device according to claim 4 or 5, wherein the measuring and control device (10) comprises a microprocessor unit and a memory for the determination and storage of the measured voltage (Vₘₑₛₛ₎ applied to its input, for opening and closing the switches (Si) in dependence on a cell to be measured as selected by a user, and for calculating the cell voltage in accordance with a method according to any of claims 1 to 3.

7. Charger comprising a device according to any of claims 4 to 6.

## Revendications

1. Procédé pour mesurer des tensions d'éléments d'accumulateur parmi plusieurs éléments d'accumulateur montés en série avec un potentiel de référence commun, avec un nombre de résistances de mesure (Ri) montées en série qui correspond au nombre d'éléments (Zi) à mesurer, et avec un nombre d'interrupteurs (S) entre les résistances de mesure et les éléments, par l'intermédiaire desquels, lorsqu'ils se ferment, l'une des résistances de mesure est apte à être reliée en parallèle à l'un des éléments, avec les étapes qui consistent :
- à fermer l'interrupteur relié à un premier pôle d'un élément à mesurer, ainsi qu'un autre interrupteur au niveau d'un pôle d'un élément avec une tension supérieure à celle de l'élément à mesurer, par rapport au potentiel de base, et à ouvrir éventuellement tous les autres interrupteurs,
- à déterminer et stocker la tension qui baisse au niveau du premier pôle par rapport au potentiel de base ;
- à ouvrir l'interrupteur relié au premier pôle de l'élément à mesurer, et à fermer l'interrupteur relié à un second pôle de l'élément à mesurer,
- à déterminer et à stocker la tension qui baisse au niveau du second pôle par rapport au potentiel de référence,
- à déterminer la tension d'élément en formant la différence entre les tensions déterminées au niveau des deux pôles.

2. Procédé selon la revendication 1, selon lequel la tension qui baisse par rapport au potentiel de référence au niveau d'un pôle d'un élément (Zi) à mesurer est déterminée grâce au fait que la tension qui baisse par l'intermédiaire d'une première résistance de mesure (R1) du montage en série de résistances de mesure (Ri) reliée au potentiel de base est mesurée et, à partir de là, la tension qui baisse au niveau du pôle est calculée en tenant compte du rapport de division entre le montage en série de résistances de mesure qui est placé entre le pôle et le potentiel de référence, et la première résistance de mesure (R1).

3. Procédé selon la revendication 2, selon lequel l'ouverture et la fermeture des interrupteurs (Si), le calcul des tensions qui baissent au niveau des pôles d'un élément (Zi) à mesurer ainsi que le calcul de la tension d'élément se font à l'aide d'un dispositif de mesure et de commande (10) commandé par microprocesseur.

4. Dispositif pour mesurer des tensions d'éléments d'accumulateur parmi plusieurs éléments d'accumulateur (Zi) montés en série avec un potentiel de référence commun, avec :
- un nombre de résistances de mesure (Ri) montées en série qui correspond au nombre d'éléments (Zi) à mesurer,
- un nombre d'interrupteurs (Si) entre les résistances de mesure et les éléments ou raccordements pour les éléments, par l'intermédiaire desquels, lorsqu'ils se ferment, l'une des résistances de mesure est apte à être reliée en parallèle à l'un des éléments, et
- un dispositif de mesure et de commande (10) pour ouvrir et fermer les interrupteurs (Si) en fonction d'un élément à mesurer choisi, et pour déterminer la tension de l'élément en formant la différence des tensions qui baissent par rapport au potentiel de référence au niveau des deux pôles de l'élément, selon un procédé selon l'une des revendications 1 à 3.

5. Dispositif selon la revendication 4, selon lequel le dispositif de mesure et de commande (10) comporte une unité de calcul et/ou une unité de stockage pour calculer et stocker au moins un rapport de division de tension entre un montage en série de résistances de mesure (R1+R2+R3...) à monter entre un pôle d'un élément (Zi) à mesurer et le potentiel de référence, et une première résistance de mesure (R1) reliée au potentiel de référence.

6. Dispositif selon la revendication 4 ou 5, selon lequel le dispositif de mesure et de commande (10) comporte une unité de microprocesseur et une mémoire pour relever et stocker la tension de mesure (Vₘₑₛₛ) appliquée à son entrée, pour ouvrir et fermer les interrupteurs (Si) en fonction d'un élément à mesurer, sélectionné par l'utilisateur, et pour calculer la tension d'élément, selon un procédé selon l'une des revendications 1 à 3.

7. Chargeur avec un dispositif selon l'une des revendications 4 à 6.
